# FASCICULE DE BREVET EUROPEEN

(11) **EP 4 768 874 B1**
(45) Date de publication et mention de la délivrance du brevet: **04.11.2026**
(21) Numéro de dépôt: 25210927.7
(22) Date de dépôt: 24.10.2025
(51) Int. Cl.: G01J 1/02, G01J 1/04, G01J 5/02, G01J 5/04

(54) **PROCEDE POUR LA REALISATION D'UN COMPOSANT HYBRIDE ET COMPOSANT HYBRIDE ASSOCIE**
VERFAHREN ZUR HERSTELLUNG EINES HYBRIDBAUTEILS UND HYBRIDBAUTEIL
METHOD FOR PRODUCING A HYBRID COMPONENT AND ASSOCIATED HYBRID COMPONENT

(30) Priorité: 24.12.2024 FR 2415212
(43) Date de publication de la demande: 01.07.2026
(73) Titulaire: LYNRED, 91120 Palaiseau (FR)
(72) Inventeur: LE BOTERF, Pascal, 38113 VEUREY-VOROIZE (FR); DUPERREX, Lucas, 38113 VEUREY-VOROIZE (FR); CANAS, Bastien, 38113 VEUREY-VOROIZE (FR)
(74) Mandataire: Ipsilon

(56) Documents cités:
- WO-A1-2013/167553
- US-A- 5 574 285

## Description

### DOMAINE DE L'INVENTION

L'invention concerne un procédé de fabrication d'un composant hybridé ainsi que le composant hybridé associé.

L'invention trouve diverses applications, notamment dans les domaines de l'astronomie, de la physique des particules et des technologies de détection avancées.

L'invention trouve une application particulièrement avantageuse pour les détecteurs infrarouges, et plus spécifiquement ceux fonctionnant à des températures cryogéniques.

### ETAT ANTERIEUR DE LA TECHNIQUE

Les composants hybridés comprennent généralement un circuit de détection monté sur un circuit de lecture avec des connexions métalliques. Une colle ou une résine, est ensuite classiquement appliquée entre le circuit de détection et le circuit de lecture pour assurer la fixation des deux circuits et protéger les connexions métalliques.

Cependant, le circuit de détection, le circuit de lecture et la colle présentent classiquement des différences de coefficients de dilatation thermique. À des températures cryogéniques, ces différences de coefficients de dilatation thermique peuvent engendrer des contraintes mécaniques importantes lors des cycles de refroidissement et de réchauffement. Ces contraintes mécaniques se manifestent sous la forme de forces de traction et de compression qui agissent sur les interfaces entre les matériaux.

En outre, du fait de la mouillabilité de la colle, celle-ci s'étend non seulement entre les circuits de lecture et de détection, mais également sur les côtés du circuit de détection. Cette extension de la colle sur les côtés peut exacerber les contraintes mécaniques, augmentant ainsi les forces de traction et de compression.

Les forces appliquées peuvent provoquer des fissures ou des délaminations, compromettant ainsi l'intégrité structurelle et fonctionnelle des composants. Les risques pour les composants incluent :
- la fissuration, où les fissures peuvent se propager à travers les interfaces, entraînant une défaillance mécanique ;
- la délamination, qui est la séparation des couches de matériaux, et qui peut entraîner une perte de contact électrique et une dégradation des performances ; et
- la défaillance thermique qui peut survenir lorsque les fissures et les délaminations altèrent la dissipation thermique, entraînant une surchauffe locale et des défaillances supplémentaires.

Au sens de l'invention, l'ensemble de ces risques est regroupé sous le terme de clivage.

Pour limiter ce risque de clivage, il est connu d'utiliser un substrat de contrainte qui compense les différences de coefficients de dilatation thermique entre les matériaux en absorbant et en redistribuant les contraintes mécaniques. Ce substrat de contrainte est généralement réalisé à partir de matériaux ayant des propriétés thermomécaniques adaptées pour minimiser les déformations et les tensions induites par les variations de température.

Cependant, l'ajout d'un substrat de contrainte augmente l'épaisseur totale de l'assemblage, ce qui peut poser des problèmes d'intégration dans des systèmes où l'espace est limité. En outre, le choix des matériaux pour le substrat de contrainte doit être soigneusement étudié pour assurer une compatibilité optimale avec les matériaux du circuit de lecture, de la colle et du circuit de détection, ce qui limite les options disponibles.

Par ailleurs, l'intégration d'un substrat de contrainte ajoute de la complexité au processus de fabrication, nécessitant des techniques de collage et d'assemblage plus sophistiquées. Enfin, l'utilisation de matériaux spécialisés pour le substrat de contrainte augmente les coûts de production.

Selon une autre solution pour limiter les contraintes, telle que décrite dans le document US20140048934, il a été proposé une méthode pour contrôler le flux de la colle en créant une rugosité de surface sur un substrat sur lequel est soudé un composant.

Cette méthode inhibe le flux de la colle et permet de former des bourrelets de colles équilibrés, réduisant ainsi les concentrations de stress élevées sur la puce. Ces bourrelets de colles sont également appelés *« filet* » dans la littérature anglo-saxonne.

Cependant, la création de rugosité de surface a un impact limité sur le risque de clivage, notamment pour les composants épais, typiquement avec une épaisseur supérieure à 200 micromètres.

Le document US6940182 propose également une méthode pour gérer la colle entre une puce intégrée et un substrat afin de réduire les contraintes mécaniques et améliorer la fiabilité du composant hybridé. Ce document propose l'utilisation d'un barrage autour de la puce pour contrôler la forme et l'accumulation de la colle afin de réduire les contraintes résultant des effets de bord. Le barrage permet de contrôler l'angle de mouillage de la colle pour fournir une composante de contrainte beaucoup plus petite selon la direction perpendiculaire à la surface du substrat sous-jacent, en réduisant le bourrelet de colle ainsi formé.

Cependant, l'utilisation d'un barrage a également un impact limité sur le risque de clivage, notamment pour les composants dont l'épaisseur peut varier entre quelques dizaines et quelques centaines de micromètres.

Le document US7301222 décrit un autre procédé pour contrôler les bourrelets de colle lors du dépôt de la colle entre une puce intégrée et un substrat en utilisant des rainures. Encore une fois, cette solution a un impact limité sur le risque de clivage, notamment pour les composants dont l'épaisseur peut varier entre quelques dizaines et quelques centaines de micromètres.

Le problème technique à résoudre réside de fait dans la réalisation d'un composant hybridé présentant un risque de clivage limité, notamment lorsque le composant hybridé est utilisé à des températures extrêmes, avec la possibilité d'utiliser une épaisseur du circuit de détection entre quelques dizaines de micromètres et quelques centaines de micromètres.

D'autres exemples de l'état de la technique sont fournis par les documents US5574285 et WO2013167553.

### EXPOSE DE L'INVENTION

Pour répondre à ce problème technique, l'invention propose de préparer le circuit de détection avec une couche sacrificielle avant qu'il ne soit fixé sur le circuit de lecture. Ainsi, la couche sacrificielle s'étend au moins sur les bords du circuit de détection et le dépôt de la colle peut être réalisé classiquement. Après le dépôt de la colle, celle-ci s'étend donc sur la couche sacrificielle ménagée sur les bords du circuit de détection, si bien que le retrait de cette couche sacrificielle entraine la formation de tranchées.

Selon un premier aspect, l'invention concerne donc un procédé de fabrication d'un composant hybridé comprenant les étapes suivantes :
- fixation d'un circuit de détection sur un circuit de lecture ; et
- application d'une colle entre le circuit de détection et le circuit de lecture.

L'invention se caractérise en ce que le procédé comporte également les étapes suivantes :
- dépôt d'une couche sacrificielle sur le circuit de détection avant l'étape de fixation du circuit de détection sur le circuit de lecture de sorte que la couche sacrificielle s'étende au moins sur les bords du circuit de détection ; et
- retrait de la couche sacrificielle après l'étape d'application de la colle entre le circuit de détection et le circuit de lecture de sorte à former des tranchées autour dudit circuit de détection.

Bien que la solution classique pour limiter le clivage préconise le contrôle du dépôt de la colle, l'invention propose une alternative dans laquelle le procédé de dépôt de la colle n'est pas contraint. En effet, l'invention met en œuvre une couche sacrificielle pour prédéterminer l'épaisseur et la forme des tranchées autour du circuit de détection.

Contrairement aux solutions de l'état de la technique, l'invention est particulièrement efficace pour les circuits de détection épais, typiquement avec une épaisseur supérieure à 200 micromètres.

Par ailleurs, avant l'étape de retrait de la couche sacrificielle, il est possible de réaliser un amincissement de la colle et du circuit de détection. Cette étape est souvent utilisée lorsque le circuit de détection est hybridé par report en utilisant un substrat sur lequel le circuit de détection est réalisé.

Une fois hybridé sur le circuit de lecture, ce substrat n'est plus nécessaire et parfois gênant d'un point de vue électro-optique. Il est donc retiré par amincissement mécanique ou chimique.

Pour obtenir une tranchée avec une dimension suffisante pour limiter le risque de clivage, le dépôt d'une couche sacrificielle est préférentiellement réalisé avec une épaisseur d'au moins 1 micromètre. Encore plus préférentiellement, le dépôt d'une couche sacrificielle est réalisé avec une épaisseur d'au moins 1.5 micromètres.

Par ailleurs, pour protéger les connexions, l'étape de dépôt de la couche sacrificielle sur le circuit de détection peut être réalisée par pulvérisation, enduction, évaporation ou tout autre méthode de dépôt d'une couche sacrificielle tout en protégeant la face du circuit de détection destinée à être fixée sur le circuit de lecture. En ce qui concerne le procédé de dépôt de la couche sacrificielle, il est ainsi possible d'utiliser tout procédé permettant de déposer une couche sacrificielle au moins sur les bords du circuit de détection, sans affecter sa face active. Cette face active correspond à la face du circuit de détection destinée à l'hybridation avec le circuit de lecture.

En outre, il est également possible d'appliquer une résine ou un adhésif temporaire de protection sur cette face active, avant l'étape de dépôt de la couche sacrificielle. Pour ce faire, la résine ou l'adhésif temporaire doit être déposé sans s'étendre sur les bords du circuit de détection. En variante, il est également possible de placer le circuit de détection sur un support protégeant la face active lors que dépôt de la couche sacrificielle.

Par ailleurs, il est possible de déposer ou non la couche sacrificielle sur la face arrière du circuit de détection, c'est-à-dire la face opposée à la face active. En effet, avant l'étape de retrait de la couche sacrificielle, il est préférable de réaliser un amincissement de la colle et du circuit de détection. Or, cette étape d'amincissement entraine la suppression la couche sacrificielle déposée sur la face arrière.

En ce qui concerne le retrait de cette couche, il peut être réalisée par gravure chimique ou dissolution. Par exemple, la couche sacrificielle peut être réalisée en sulfure de zinc et l'étape de retrait de la couche sacrificielle est réalisée par acide chlorhydrique. L'acide chlorhydrique permet de retirer le sulfure de zinc sans attaquer une colle en époxy ou le circuit de détection qui pourrait être en antimoniure de gallium ou en tellurure de cadmium-zinc.

Bien entendu, d'autres matériaux peuvent être utilisés par la couche sacrificielle et l'étape de retrait de la couche sacrificielle, en fonction des matériaux constitutifs de la colle et du circuit de détection.

De préférence, pour enlever toute trace d'un traitement chimique, le procédé comporte également une étape de rinçage du composant hybridé réalisée après l'étape de retrait de la couche sacrificielle.

Selon un second aspect, l'invention concerne un composant hybridé comprenant :
- un circuit de lecture ;
- un circuit de détection fixé sur le circuit de lecture par l'intermédiaire de connexions, le circuit de détection présentant une épaisseur pouvant varier entre quelques dizaines et quelques centaines de micromètres ;
- une colle s'étendant entre le circuit de lecture et le circuit de détection et autour des connexions ; et
- des tranchés ménagées autour des bords du circuit de détection et sur toute la hauteur du circuit de détection au moyen du procédé de réalisation selon le premier aspect de l'invention.

### BREVE DESCRIPTION DES FIGURES

La manière dont l'invention peut être réalisée et les avantages qui en découlent ressortiront mieux de l'exemple de réalisation qui suit, donné à titre indicatif et non limitatif, à l'appui des figures annexées.
La figure 1 est un ordinogramme des étapes d'un procédé de fabrication d'un composant hybridé selon un mode de réalisation de l'invention ;
La figure 2 est une représentation schématique en section d'une première étape de fabrication du procédé de la figure 1 ;
La figure 3 est une représentation schématique en section d'une seconde étape de fabrication du procédé de la figure 1 ;
La figure 4 est une représentation schématique en section d'une troisième étape de fabrication du procédé de la figure 1 ;
La figure 5 est une représentation schématique en section d'une quatrième étape de fabrication du procédé de la figure 1 ; et
La figure 6 est une représentation schématique en section d'une cinquième étape de fabrication du procédé de la figure 1.

### DESCRIPTION DETAILLEE DE L'INVENTION

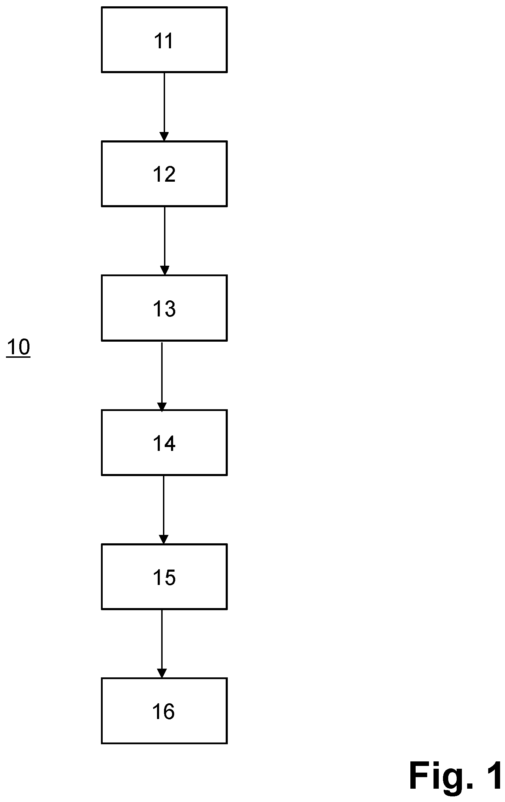

La figure 1 illustre un procédé de fabrication 10 d'un composant hybridé 20, comprenant un circuit de lecture 22 et un circuit de détection 21.

Selon l'invention, le procédé de fabrication comporte une première étape 11 de dépôt d'une couche sacrificielle 23 sur le circuit de détection 21. Dans cette étape 11, la couche sacrificielle 23 peut être déposée par tous les procédés connus de dépôt d'une couche sacrificielle, et notamment par pulvérisation, enduction, évaporation ou tout autre méthode de dépôt d'une couche sacrificielle.

De préférence, lors du dépôt de cette couche sacrificielle 23, la face du circuit de détection 21 destinée à être fixée sur le circuit de lecture 22 est protégée. En outre, l'étape de dépôt 11 de la couche sacrificielle 23 est préférentiellement réalisée en contrôlant l'épaisseur de la couche sacrificielle 23, typiquement pour obtenir une épaisseur d'au moins 1 micromètre et préférentiellement d'au moins 1,5 micromètres. Par exemple, une épaisseur de 2 micromètres peut ainsi être recherchée. En ce qui concerne le matériau constitutif de cette couche sacrificielle 23, elle peut être réalisée en sulfure de zinc ou en tout autre matériau adapté à être retiré par gravure chimique ou dissolution.

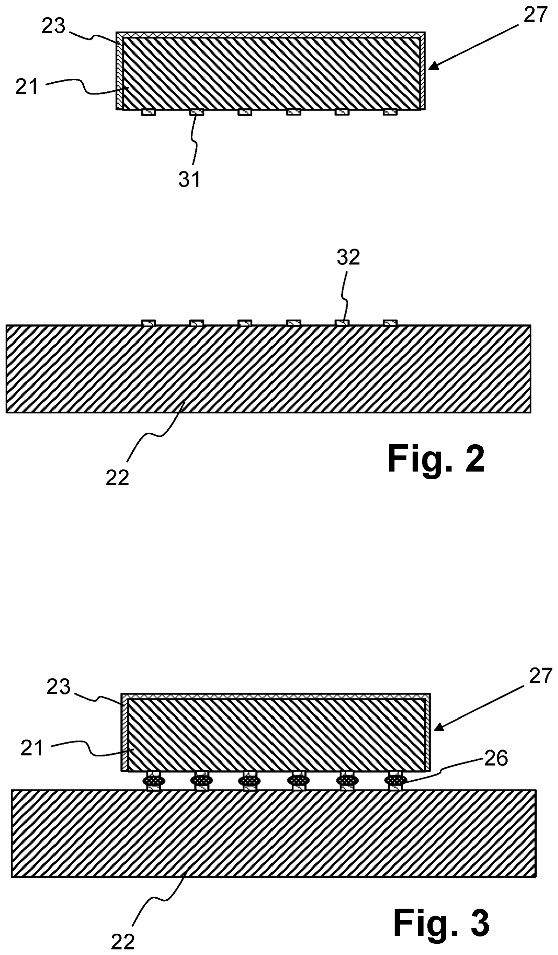

Après cette étape 11 de dépôt de la couche sacrificielle, tel qu'illustré sur la figure 2, les connecteurs 31 du circuit de détection 21 sont placés en regard des connecteurs 32 du circuit de lecture 22.

Dans la seconde étape **12,** le circuit de détection **21** est fixé sur le circuit de lecture **22** en appliquant une soudure entre ces connecteurs **31** et **32,** formant ainsi une connexion **26,** tel qu'illustré sur la figure 3.

Une colle **24** est ensuite appliquée, lors de l'étape **13,** entre le circuit de détection **21** et le circuit de lecture **22.**

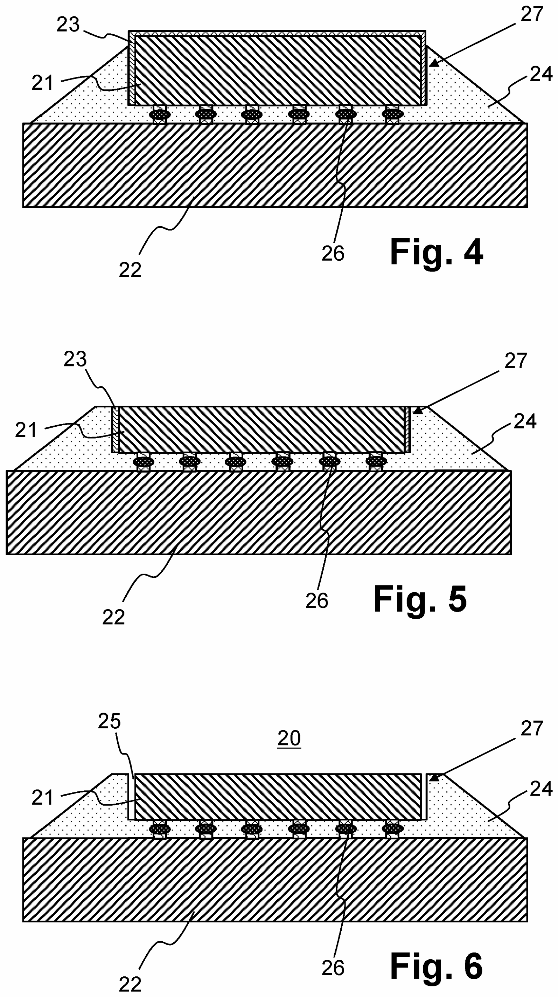

Tel qu'illustré sur la figure 4, cette colle **24** s'étend entre les connexions **26** mais également au niveau des bords **27** du circuit de détection **21.**

Ensuite, il est possible de prévoir une étape **14** d'amincissement du circuit de détection 21, ce qui entraîne également une suppression d'une partie supérieure de la colle 24 et de la couche sacrificielle **23,** tel qu'illustré sur la figure 5.

Lors d'une étape **15,** la couche sacrificielle **23** est retirée, préférentiellement par gravure chimique ou dissolution. Lorsque la couche sacrificielle **23** est réalisée en sulfure de zinc, une gravure chimique peut être réalisée à l'aide d'acide chlorhydrique.

Suite à cette étape de retrait de la couche sacrificielle **23,** des tranchées **25** sont formées sur les bords du circuit de détection **21.**

En outre, il est également possible de mettre en œuvre une dernière étape, en l'espèce de rinçage **16** du composant hybride **20** formé par ces différentes étapes, de sorte à limiter les résidus possibles d'acide chlorhydrique ou de tout autre matériau de gravure utilisé.

Tel qu'illustré sur la figure 6, l'invention permet ainsi d'obtenir un composant hybridé **20** avec des tranchées **25** réalisées sur les bords **27** du circuit de détection **21.**

L'invention permet de ménager ces tranchées **25** simplement, même avec un circuit de détection **21** présentant une épaisseur pouvant varier entre quelques dizaines et quelques centaines de micromètres.

L'invention permet d'obtenir un composant hybridé **20** avec un risque de clivage limité puisque la colle **24** ne s'étend plus au contact des bords **27** du circuit de détection **21.**

## Revendications

1. Procédé de réalisation (10) d'un composant hybridé (20) comprenant les étapes suivantes :
- fixation (12) d'un circuit de détection (21) sur un circuit de lecture (22) ; et
- application (13) d'une colle (24) entre le circuit de détection (21) et le circuit de lecture (22) ;
***caractérisé en ce que* le** procédé comprend également les étapes suivantes :
- dépôt (11) d'une couche sacrificielle (23) sur le circuit de détection (21) avant l'étape de fixation (12) du circuit de détection (21) sur le circuit de lecture (22), de sorte que la couche sacrificielle (23) s'étende au moins sur les bords (27) du circuit de détection (21) ; et
- retrait (15) de la couche sacrificielle (23) après l'étape d'application (13) de la colle (24) entre le circuit de détection (21) et le circuit de lecture (22) de sorte à former des tranchées (25) autour dudit circuit de détection (21).

2. Procédé de réalisation d'un composant hybridé selon la revendication 1, ***dans lequel,*** avant l'étape de retrait (15) de la couche sacrificielle (23), le procédé comporte également une étape d'amincissement (14) de la colle (24) et du circuit de détection (21).

3. Procédé de réalisation d'un composant hybridé selon la revendication 1 ou 2, ***dans lequel*** l'épaisseur de la couche sacrificielle (23) déposée sur le circuit de détection (21) est d'au moins 1 micromètre.

4. Procédé de réalisation d'un composant hybridé selon la revendication 3, ***dans lequel*** l'épaisseur de la couche sacrificielle (23) déposée sur le circuit de détection (21) est d'au moins 1.5 micromètres.

5. Procédé de réalisation d'un composant hybridé selon l'une des revendications 1 à *4, **dans lequel*** l'étape de dépôt (11) de la couche sacrificielle (23) sur le circuit de détection (21) est réalisée par pulvérisation, enduction, évaporation ou tout autre méthode de dépôt d'une couche sacrificielle tout en protégeant la face du circuit de détection (21) destinée à être fixée sur le circuit de lecture (22).

6. Procédé de réalisation d'un composant hybridé selon l'une des revendications 1 à *5, **dans lequel*** l'étape de retrait (15) de la couche sacrificielle (23) est réalisée par gravure chimique ou dissolution.

7. Procédé de réalisation d'un composant hybridé selon la revendication 6, ***dans lequel*** la couche sacrificielle (23) est réalisée en sulfure de zinc et l'étape de retrait (15) de la couche sacrificielle (23) est réalisée par acide chlorhydrique.

8. Procédé de réalisation d'un composant hybridé selon la revendication 7 ou 8, ***dans lequel*** le procédé comporte également une étape de rinçage (16) du composant hybridé (20) réalisée après l'étape de retrait (15) de la couche sacrificielle (23).

9. Composant hybridé (20) comportant :
- un circuit de lecture (22) ;
- un circuit de détection (21) connecté au circuit de lecture (22) par l'intermédiaire de connexions (26), le circuit de détection (21) présentant une épaisseur pouvant varier entre quelques dizaines et quelques centaines de micromètres ;
- une colle (24) s'étendant entre le circuit de lecture (22) et le circuit de détection (21) et autour des connexions (26) ; et
- des tranchées (25) ménagées autour des bords (27) du circuit de détection (21) et sur toute la hauteur du circuit de détection (21) au moyen du procédé de réalisation selon l'une des revendications 1 à 8.

## Patentansprüche

1. Verfahren (10) zur Herstellung eines Hybridbauteils (20), das folgende Schritte umfasst:
- Befestigen (12) einer Detektorschaltung (21) auf einer Leseschaltung (22); und
- Auftrag (13) eines Klebstoffs (24) zwischen der Detektorschaltung (21) und der Leseschaltung (22);
***dadurch gekennzeichnet*, dass** das Verfahren außerdem folgende Schritte umfasst:
- Auftragen (11) einer Opferschicht (23) auf die Detektorschaltung (21) vor dem Schritt (12) der Befestigung der Detektorschaltung (21) an der Leseschaltung (22), so dass sich die Opferschicht (23) mindestens über die Ränder (27) der Detektorschaltung (21) erstreckt; und
- Entfernen (15) der Opferschicht (23) nach dem Schritt des Auftrags (13) des Klebstoffs (24) zwischen der Detektorschaltung (21) und der Leseschaltung (22), um auf diese Weise Gräben (25) um die Detektorschaltung (21) herum zu bilden.

2. Verfahren zur Herstellung eines Hybridbauteils nach Anspruch 1, ***wobei*** das Verfahren vor dem Schritt der Entfernung (15) der Opferschicht (23) außerdem einen Schritt (14) zur Verdünnung des Klebstoffs (24) und der Detektorschaltung (21) umfasst.

3. Verfahren zur Herstellung eines Hybridbauteils nach Anspruch 1 oder 2, ***wobei*** die Opferschicht (23), die auf die Detektorschaltung (21) aufgetragen wird, mindestens 1 Mikrometer dick ist.

4. Verfahren zur Herstellung eines Hybridbauteils nach Anspruch 3, ***wobei*** die die Opferschicht (23), die auf die Detektorschaltung (21) aufgetragen wird, mindestens 1,5 Mikrometer dick ist.

5. Verfahren zur Herstellung eines Hybridbauteils nach einem der Ansprüche 1 bis 4, ***bei dem*** die Opferschicht (23) auf die Detektorschaltung (21) durch Sprühen, Beschichtung, Eindampfung oder ein anderes Verfahren zum Auftrag einer Opferschicht aufgetragen (11) wird, wobei die Seite der Detektorschaltung (21), die an der Leseschaltung (22) befestigt werden soll, geschützt wird.

6. Verfahren zur Herstellung eines Hybridbauteils nach einem der Ansprüche 1 bis 5, ***wobei*** die Opferschicht (23) durch chemisches Ätzen oder Auflösen in einem Schritt entfernt (15) wird.

7. Verfahren zur Herstellung eines Hybridbauteils nach Anspruch 6, ***wobei*** die Opferschicht (23) aus Zinksulfid besteht und die Opferschicht (23) in einem Schritt mit Salzsäure entfernt (15) wird.

8. Verfahren zur Herstellung eines Hybridbauteils nach Anspruch 7 oder 8, ***wobei*** das Verfahren außerdem einen Schritt umfasst, bei dem das Hybridbauteil (20) gespült (16) wird, der durchgeführt wird, nachdem die Opferschicht (23) entfernt wurde.

9. Hybridbauteil (20) mit:
- einer Leseschaltung (22);
- einer Detektorschaltung (21), die über Anschlüsse (26) mit der Leseschaltung (22) verbunden ist, wobei die Detektorschaltung (21) zwischen einigen Dutzend und einigen Hundert Mikrometern Dicke variieren kann;
- einem Klebstoff (24), der sich zwischen der Leseschaltung (22) und der Detektorschaltung (21) sowie um die Anschlüsse (26) herum erstreckt; und
- Gräben (25), die um die Ränder (27) der Detektorschaltung (21) herum und über die gesamte Höhe der Detektorschaltung (21) mit dem Herstellungsverfahren nach einem der Ansprüche 1 bis 8 ausgebildet sind.

## Claims

1. A method of manufacturing (10) a hybridized component (20) comprising the following steps:
- attaching (12) of a detection circuit (21) to a readout circuit (22); and
- application (13) of glue (24) between the detection circuit (21) and the readout circuit (22);
***characterized in that*** the method also comprises the following steps:
- deposition (11) of a sacrificial layer (23) on the detection circuit (21) before the step of attaching (12) of the detection circuit (21) to the readout circuit (22), so that the sacrificial layer (23) extends at least over edges (27) of the detection circuit (21); and
- removal (15) of the sacrificial layer (23) after the step of application (13) of the glue (24) between the detection circuit (21) and the readout circuit (22) so as to form trenches (25) around said detection circuit (21).

2. The method of manufacturing a hybridized component according to claim 1, ***wherein***, before the step of removal (15) of the sacrificial layer (23), the method also comprises a step of thinning (14) of the glue (24) and of the detection circuit (21).

3. The method of manufacturing a hybridized component according to claim 1 or 2, ***wherein*** the thickness of the sacrificial layer (23) deposited on the detection circuit (21) is at least 1 micrometer.

4. The method of manufacturing a hybridized component according to claim 3, ***wherein*** the thickness of the sacrificial layer (23) deposited on the detection circuit (21) is at least 1.5 micrometers.

5. The method of manufacturing a hybridized component according to one of claims 1 to 4, ***wherein*** the step of deposition (11) of the sacrificial layer (23) on the detection circuit (21) is carried out by sputtering, coating, evaporation, or any other method of deposition of a sacrificial layer while protecting the surface of the detection circuit (21) intended to be attached to the readout circuit (22).

6. The method of manufacturing a hybridized component according to one of claims 1 to 5, ***wherein*** the step of removal (15) of the sacrificial layer (23) is carried out by chemical etching or dissolution.

7. The method of manufacturing a hybridized component according to claim 6, ***wherein*** the sacrificial layer (23) is made of zinc sulfide and the step of removal (15) of the sacrificial layer (23) is carried out with hydrochloric acid.

8. The method of manufacturing a hybridized component according to claim 7 or 8, ***wherein*** the method also comprises a step of rinsing (16) of the hybridized component (20) carried out after the step of removal (15) of the sacrificial layer (23).

9. A hybridized component (20) comprising:
- a readout circuit (22);
- a detection circuit (21) connected to the readout circuit (22) via connections (26), the detection circuit (21) having a thickness capable of varying between a few tens and a few hundreds of micrometers;
- glue (24) extending between the readout circuit (22) and the detection circuit (21) and around the connections (26); and
- trenches (25) formed around the edges (27) of the detection circuit (21) and along the entire height of the detection circuit (21) by means of the manufacturing method according to one of claims 1 to 8.
